**Europäisches Patentamt**

**European Patent Office**

**Office européen des brevets**

(11) Numéro de publication: **0 165 104 B1**

## (12) FASCICULE DE BREVET EUROPEEN

(45) Date de publication du fascicule du brevet:
24.08.88

(51) Int. Cl.⁴: **B 23 P 6/04,** B 23 K 1/20, B 23 K 35/24

(21) Numéro de dépôt: **85400855.4**

(22) Date de dépôt: **02.05.85**

(54) **Procédé de réparation par diffusion.**

(30) Priorité: **17.05.84 FR 8407648**

(43) Date de publication de la demande:
**18.12.85 Bulletin 85/51**

(45) Mention de la délivrance du brevet:
**24.08.88 Bulletin 88/34**

(84) Etats contractants désignés:
**BE CH DE FR GB IT LI NL SE**

(56) Documents cités:
**EP - A - 0 024 142**
**EP - A - 0 095 607**
**FR - A - 2 296 491**
**FR - A - 2 383 750**
**FR - A - 2 511 908**
**GB - A - 1 454 217**

(73) Titulaire: **SOCIETE NATIONALE D'ETUDE ET DE CONSTRUCTION DE MOTEURS D'AVIATION, "S.N.E.C.M.A.", 2 Boulevard Victor, F-75015 Paris (FR)**

(72) Inventeur: **Fournes, Jean Paul, 17, rue de la Messe Dannemois, F-91490 Milly La Forêt (FR)**
Inventeur: **Lesgourgues, Jacques, 7 bis, Boulevard Ambroise Croizat, F-91100 Corbeil (FR)**
Inventeur: **Martinou, Robert Lucien, 47, Avenue du Général Leclerc, F-94360 Bry Sur Marne (FR)**

(74) Mandataire: **Moinat, François, S.N.E.C.M.A. Service des Brevets Boîte Postale 81, F-91003 Evry Cédex (FR)**

ACTORUM AG

## Description

L'invention concerne la réparation de pièces en alliages résistant à chaud à base de nickel, cobalt ou fer endommagées ou fissurées après une exposition prolongée à des gaz à haute température tels que les gaz de combustion de turbomachine.

Le document FR-A 2 511 908 au nom de la requérante se rapporte à un procédé de brasage diffusion destiné aux pièces en de tels alliages résistant à chaud appelés aussi superalliages.

Dans le premier exemple décrit, on applique ce procédé à la réparation d'une aube fixe de turbine coulée de précision en un alliage à base de cobalt dégradée par fissuration en fatigue thermique. La gamme opératoire de reconditionnement est la suivante:
- on remplit les fissures les plus fines avec un métal d'apport sous forme de poudre préalliée mélangée avec un liant volatil. Cet alliage est à base nickel-chrome; il contient un fondant tel que le bore en proportion suffisante pour le rendre plus fusible que l'alliage de la pièce; ce fondant est de plus capable de diffuser dans cette dernière.
- On fait fondre le métal d'apport par passage à 1200°C pendant 15 minutes sous vide.
- On dépose un matériau de rechargement sur les parties endommagées dont l'ouverture plus importante que les fissures précédentes ne permet pas le traitement par application d'un simple métal d'apport. Ce matériau de rechargement est constitué d'un mélange d'une poudre d'alliage à base de cobalt et d'une poudre de métal d'apport à base de nickel-cobalt avec les fondants silicium et bore.
- On fait fondre le métal d'apport par passage à 1200°C pendant 15 minutes sous vide.
- Enfin, on fait subir à la pièce un traitement de diffusion à 1200°C pendant 4 heures sous vide.

Dans ce brevet, on suppose les pièces nettoyées et prêtes pour leur reconditionnement. Cependant, pour garantir de bons résultats lorsqu'on applique ce procédé, il faut veiller à l'état de surface des pièces en particulier dans les fissures. En effet, en fonctionnement ces pièces se recouvrent d'une couche contaminée de composés chimiques notamment des oxydes complexes et des oxysulfures d'aluminium, de titane et de chrome, constituants de l'alliage. Si ces couches ne sont pas éliminées, elles conduisent à une mauvaise mouillabilité des parois des fissures par le métal d'apport en fusion, et ne permettent pas à ce dernier de colmater entièrement les fissures. Ces dépôts de composés complexes sont très stables et tenaces et leur enlèvement n'est pas aisé.

La présente invention vise donc un perfectionnement à ce procédé et porte en particulier sur la préparation des pièces avant leur reconditionnement.

On sait, par le document FR-A 2 383 750 par exemple, nettoyer les pièces en superalliage, avant brasage, au moyen d'un traitement par voie thermochimique. Celui-ci consiste à placer la pièce dans une enceinte chauffée et parcourue par de l'hydrogène en présence d'un composé halogène, fluorure d'ammonium par exemple, qui libère des ions fluor; ces derniers réagissent avec les oxydes en surface pour former des fluorures métalliques, gazeux à la température de réaction, laissant le métal à nu.

Ce traitement est efficace car le produit actif, étant à l'état gazeux, peut agir et nettoyer les fissures en profondeur. Il présente cependant de nombreux inconvénients:
- on constate qu'il ne permet pas de décomposer toutes les couches en surface. Les oxysulfures en particulier résistent à ce traitement et rendent impossible tout reconditionnement ultérieur.
- On ne peut prolonger trop longtemps ce traitement pour essayer d'éliminer ces composés, car on assiste alors à une dégradation du substrat par modification de la composition superficielle; en effet, certains éléments tels le titane, le tungstène, l'aluminium constituant l'alliage sont éliminés en priorité. Les pièces vieillies sont particulièrement vulnérables car leur composition en surface est elle-même déjà modifiée par suite de leur exposition prolongée aux gaz chauds de combustion. Un tel traitement accentue donc leur dégradation.
- Un traitement prolongé conduit également à une corrosion inter-granulaire plus ou moins importante suivant l'état de vieillissement des pièces.
- Enfin, on ne peut appliquer ce traitement à certains éléments tels les chambres de combustion qui sont constituées d'une pluralité de viroles assemblées par brasage car l'atmosphère fluorée attaque fortement le métal fondu de la brasure.

On a proposé de nettoyer les pièces par des moyens mécaniques. Le brevet US-A 4 285 459 par exemple, décrit un procédé de réparation de pièces en superalliage dans lequel on creuse chaque fissure au moyen d'un outil de façon à garantir l'enlèvement des dépôts indésirables d'une part, à ouvrir suffisamment la fissure d'autre part. De la sorte on facilite l'opération ultérieure de brasage. Cette méthode n'est évidemment applicable que si le nombre de fissures n'est pas trop élevé car elle est couteuse et difficile.

Le document FR-A 2 560 893 au nom de la requérante se rapporte à un bain de décapage chimique et notamment à son application à la désoxysulfuration de pièces fissurées devant être réparées par brasage-diffusion. Les résultats obtenus sont très satisfaisants en ce qui concerne l'état de surface hors des fissures. Ce moyen de nettoyage permet de traiter tous les cas de composés connus sans altérer la qualité de la matière. Toutefois, dans le cas de fissures profondes et de faible largeur l'enlèvement est insuffisant, à cause de la saturation rapide du liquide à l'intérieur des fissures; celles-ci formant un espace confiné, les échanges avec l'extérieur et le renouvellement local du bain sont très limités.

Conformément à l'invention, on associe un traitement par voie chimique de ce type à un traitement par voie thermochimique pour préparer les pièces fissurées et endommagées avant leur réparation par un procédé de brasage-diffusion. Après avoir subi un traitement initial par voie chimique les pièces sont parfaitement nettoyées en surface et les fissures dégagées au moins partiellement. On applique alors le traitement thermochimique uniquement comme parachèvement du premier nettoyage. En effet, la préparation initiale permet de réduire la durée de ce traitement et le nettoyage est terminé avant l'apparition de toute dégradation du substrat métallique.

En conséquence des considérations précédentes, on a mis au point une gamme complète de réparation de pièces en superalliages. Elle comprend 4 étapes essentielles.

La première étape consiste à nettoyer les surfaces chimiquement par immersions successives dans des bains différents avec des rinçages intermédiaires. Elle comprend un premier décalaminage dans des bains acides ou alcalins tels que ceux connus dans le commerce sous le nom de Turco 4181 ou Ardrox 1871 (marques déposées). Ce décalaminage est suivi d'un conditionnement des oxydes plus résistants dans un bain au permanganate alcalin tel que celui connu dans le commerce sous le nom de Turco 4338 C (marque déposée) ou bien dans un bain de soude fondu. Par ce conditionnement les oxydes sont transformés en éléments solubles et aptes à être enlevés par bain acide dans lequel les pièces sont plongées ensuite. Dans les gammes usuelles de désoxydation, ce bain acide est à base d'acide nitrique et d'acide fluorhydrique; cependant il est apparu que suivant les proportions celui-ci était la cause d'une corrosion inter-granulaire importante du substrat métallique ou bien était inactif sur les dépôts d'oxysulfures particulièrement tenaces. Conformément à une caractéristique supplémentaire de l'invention, le bain de désoxydation utilisé est une solution aqueuse d'acide chlorhydrique, d'acide nitrique, d'acide acétique et d'acide phosphorique contenant en outre un sel de fer. Cette composition de bain est reprise dans le document FR-A2 560 893

Ce bain est efficace quand les divers élémemts se retrouvent dans les fourchettes de concentration suivantes:

| | |
|---|---|
| Eau: | 180 ± 50 ml/1 |
| Sulfate de Fer: | 160 ± 45 g/1 |
| Acide chlorhydrique: | 460 ± 100 ml/1 |
| Acide nitrique: | 160 ± 40 ml/1 |
| Acide acétique: | 115 ± 20 ml/1 |
| Acide phosphorique: | 85 ± 15 ml/1 |

On ne modifie pas les propriétés du mélange en remplaçant le sulfate de fer par du chlorure de fer associé à de l'acide sulfurique. Le temps d'immersion de la pièce est compris entre trois et dix minutes, la température du bain est comprise entre 20 et 35°C. Suivant l'épaisseur du dépôt, on répète plusieurs fois le cycle de conditionnement d'oxyde et de décapage chimique. Afin d'accélérer l'action des bains, il est également possible de prévoir en début de cycle une opération de projection de grenaille métallique destinée à fracturer la couche d'oxyde. On augmente également l'efficacité du rinçage et on améliore son action en profondeur en soumettant les bains de rinçage à une agitation ultra-sonore.

Une fois les pièces décapées et propres, on passe à l'étape suivante de nettoyage thermochimique pour son action sur les fissures. Un exemple de réalisation consiste à utiliser une enceinte semi-étanche placée dans un four à atmosphère contrôlée d'hydrogène; dans l'enceinte, on dispose la pièce et un cément capable de fournir les composés nécessaires à la réaction. Ce cément contient un matériau libérant des ions fluor tel le fluorure d'ammonium et du chrome en granulés. A la température de réaction, les oxydes sont transformés en fluorures métalliques gazeux qui sont entraînés par le flux d'hydrogène. On maintient la chaleur à l'intérieur du four de façon à ne pas dépasser 1100°C, de préférence 1050°C. Par suite de la préparation chimique initiale, la durée de ce traitement est limitée à moins de 30 minutes, 15 minutes de préférence.

Les pièces étant ainsi préparées, on procède aux deux étapes suivantes de colmatage des fissures en utilisant les matériaux définis dans le document FR-A 2 511 908.

Dans la troisième étape, on prépare sous forme de poudre mélangée à un liant volatile ou bien sous forme de feuillard fin d'épaisseur inférieure à 100 microns, un métal d'apport constitué en un alliage à base de nickel ou de cobalt avec des adjonctions d'un élément d'apport, bore et/ou silicium. Il peut s'agir d'un alliage nickel-chrome-bore ou d'un alliage nickel-cobalt-silicium-bore. On dépose la poudre sur les défauts visibles et les feuillards sur des surfaces entières susceptibles de présenter des défauts non visibles.

Dans le cas où on utilise le silicium cette technique de feuillard présente l'avantage supplémentaire d'apporter en surface de la pièce un élément qui améliore sa résistance à l'oxydation.

On fait subir un cycle thermique de simple brasage au four sous vide avec montée en température par paliers jusqu'à la température de brasage. On maintient le four à cette température pendant 15 minutes avant de refroidir les pièces. Cette étape a pour but de colmater les crevasses les plus fines dont l'ouverture n'excède pas 50 à 100 microns. Le palier à la température de brasage permet la fusion du métal d'apport et le mouillage des défauts fins mais en limitant sa durée à 15 minutes, on ne permet pas au travail métallurgique de la diffusion de s'opérer totalement.

Dans la quatrième étape, on applique sur toute la surface des défauts visibles, un mélange de poudres de composition globale proche d'un superalliage classique. Ce mélange est constitué d'au-moins deux poudres; une première dite poudre de base ne contenant pas d'élément d'apport et d'une deuxième poudre dite poudre d'apport contenant au-moins du nickel ou du cobalt et comportant au-moins un élément d'apport qui le rend plus fusible que l'alliage de la pièce et de la poudre de base. On fait subir ensuite un cycle thermique semblable à celui de l'étape précédente afin de constituer un alliage intime et le faire mouiller sur la surface de la piéce.

On applique enfin le traitement thermique de diffusion sous vide généralement plus de 4 heures et moins de 16 heures. Ce traitement permet par la diffusion complète et réciproque des éléments en présence, une homogénéisation de la zone de liaison dont la qualité est alors du même ordre que celle du matériau de base.

Le procédé a été appliqué à la réparation des jupes d'une chambre de combustion en alliage base cobalt KCN22W (marque commerciale déposée HA 188):

– la préparation des pièces a consisté en un nettoyage chimique réalisé en deux cycles comprenant chacun l'immersion successivement dans un bain de décalaminage alcalin puis acide, un bain de conditionnement d'oxyde au permanganate alcalin, un bain au sulfate de fer dont la composition a été définie plus haut; pour ce dernier le temps d'immersion a été limité à 7 minutes. Chaque cycle comprend également un grenaillage à l'aide d'une poudre métallique de granulométrie 60 à 120 microns, sous une pression de 6 bars. Chaque bain de rinçage ainsi que le bain de blanchiment final a été soumis à une agitation ultra-sonore.

– Le nettoyage a été parachevé par un traitement thermochimique en atmosphère fluorée, à 1050°C pendant 15 minutes.

– Une fois les pièces ainsi préparées, on a déposé le métal d'apport, un alliage Ni-Co-Si-B sous forme de poudre mélangée à un liant organique sur les têtes des fissures et le long des plus gros défauts. On a déposé également ce métal d'apport sous forme de feuillard fin de 40 microns d'épaisseur sur tous les bords du feston.

On a appliqué le premier cycle thermique de brasage au four sous vide: 1200°C pendant 15 minutes.

– On a déposé pour reboucher tous les défauts et manques de matières visibles, le mélange constitué d'une poudre de base d'un alliage à base nickel et d'une poudre d'apport en alliage Ni-Co-Si-B.

On a appliqué le deuxième cycle thermique de brasage au four sous vide: 1210°C pendant 15 minutes.

Enfin après vérification de la bonne réalisation de l'opération de colmatage le cycle de diffusion final a été réalisé: 8 h à 1160°C.

Après ce cycle complet, l'examen a permis notamment de constater que les métaux liquides avaient correctement mouillé le substrat et que tous les défauts étaient rebouchés.

## Revendications

1. Procédé de réparation pour des pièces en alliages résistant à chaud à base nickel, cobalt ou fer fissurées et endommagées après exposition à des gaz à haute température notamment des gaz de combustion de turbomachine et comportant en surface une couche contaminée de composés chimiques, caractérisé en ce qu'il comprend la succession d'opérations suivantes:

a) Nettoyages par voie chimique des surfaces de façon à enlever ladite couche recouvrant la pièce à réparer, lesdits nettoyages comportant les étapes suivantes:

1) décalaminage dans un bain acide ou alcalin suivi d'un rinçage;
2) conditionnement des oxydes dans un bain au permanganate alcalin ou dans un bain de soude fondu suivi d'un rinçage;
3) immersion dans un bain acide constitué d'une solution aqueuse d'acide chlorhydrique, d'acide nitrique, d'acide acétique, d'acide phosphorique contenant en outre un sel ferrique, suivi d'un rinçage;

b) Parachèvement de la préparation par un traitement par voie thermochimique dans une enceinte semi-étanche comprenant un cément à base de fluorure d'ammonium et de chrome, ladite enceinte étant placée dans un four à atmosphère contrôlée d'hydrogène.

c) Dépôt sur la surface et les défauts visibles d'un métal d'apport constitué en un alliage à base de nickel ou de cobalt et comportant un élément d'apport qui le rend plus fusible que l'alliage de ladite pièce et capable de diffuser dans celle-ci.

d) Cycle thermique de brasage permettant la fusion du métal d'apport et le mouillage des surfaces avec montée en température par paliers jusqu'à température de brasage et maintien en température pendant 15 minutes.

e) Dépôt sur la surface des défauts visibles d'un mélange constitué d'au-moins deux poudres, une première poudre dite poudre de base ne contenant substantiellement pas d'éléments d'apport et d'une deuxième poudre dite poudre d'apport contenant au-moins du nickel ou du cobalt et comportant au-moins un élément d'apport qui la rend plus fusible que l'alliage de ladite pièce et de ladite poudre de base.

f) Deuxième cycle thermique de brasage permettant l'alliage intime du mélange et son mouillage sur la surface.

g) Traitement thermique de diffusion sous vide pendant une durée comprise entre 4 et 16 heures permettant une homogénéisation suffisante de la zone réparée.

2. Procédé selon la revendication précédente caractérisé en ce qu'à l'étape de nettoyage par voie chimique est associée au-moins une opération de projection de grenaille métallique.

3. Procédé selon l'une des revendications précédentes caractérisé en ce que les bains de rinçage dans l'étape de nettoyage par voie chimique sont soumis à une agitation ultra-sonore.

4. Procédé selon l'une des revendications précédentes caractérisé en ce que le temps du traitement par voie thermochimique est inférieur à 30 minutes.

5. Procédé selon l'une des revendications précédentes caractérisé en ce que le temps du traitement par voie thermochimique est de 15 minutes.

## Patentansprüche

1. Reparaturverfahren für wärmebeständige Legierungsstücke auf Nickel, Kobalt- oder Eisenbasis mit Rissen und Beschädigungen nach Beanspruchung durch Gas hoher Temperatur, insbesondere durch Verbrennungsgase von Turbomaschinen, und die auf der Oberfläche eine mit chemischen Verbindungen kontaminierte Schicht bilden, gekennzeichnet durch folgenden Verfahrensablauf:
a) chemische Reinigung der Oberflächen um diese, das zu reparierende Stück überdeckende Schicht, abzuheben, wobei die Reinigung folgende Schritte umfasst:

1) Entzundern in einem sauren oder alkalischen Bad mit anschliessender Spülung;
2) Aufbereitung der Oxyde in einem Bad eines alkalischen Permanganats oder in einem Bad geschmolzenen Natriumcarbonats mit anschliessender Spülung;
3) Eintauchen in ein Säurebad, das aus einer wässrigen Lösung von Salzsäure, Salpetersäure, Essigsäure, Phosporsäure, die zusätzlich Eisen (III)-Salz enthält besteht, mit anschliessender Spülung;
b) Zurichten der Zubereitung durch eine thermochemische Behandlung innerhalb einer halbdurchlässigen Umschliessung, die ein Einsatzpulver auf Basis von Fluorammonium und Chrom enthält, wobei diese Umschliessung innerhalb eines Ofens mit kontrollierter Wasserstoffatmosphäre angeordnet ist;
c) Abscheidung eines Zusatzmetalles an der Oberfläche und dem sichtbaren Fehlstellen, das aus einer Legierung auf Nickel- oder Kobaltbasis besteht und ein Zusatzelement enthält, das eine grössere Schmelzbarkeit wie die Legierung dieses Stückes erreicht und geeignet ist, in dieses zu diffundieren;
d) Ein thermischer Löt-Zyklus, der die Fusion des Zusatzmetalls und die Benetzung der Oberflächen mit stufenweise ansteigender Temperatur bis zur Löt-Temperatur und die Temperatur-Konstanz während 15 Minuten erlaubt;
e) Abscheidung eines Gemisches an der Oberfläche von sichtbaren Fehlstellen, das wenigstens zwei Pulverstoffe enthält, einen ersten Pulverstoff als Basispulverstoff, der im wesentlichen kleine Elemente des Zusatzmetalls aufweist und einen zweiten Pulverstoff als Zusatzpulverstoff, der wenigstens Nickel oder Kobalt enthält und wenigstens ein Zusatzelement aufweist, das eine grössere Schmelzbarkeit wie die Legierung dieses Stückes und des Basispulverstoffs erreicht;
f) Ein zweiter thermischer Löt-Zyklus, der der Legierung eine intensive Verbindung mit dem Gemisch und der Benetzung auf der Oberfläche erlaubt;

g) Thermische Diffusions-Behandlung unter Vakuum während einer Zeitdauer zwischen 4 und 16 Stunden, die eine hinreichende Homogenisierung der reparierten Zone erlaubt.
2. Verfahren nach dem vorhergehenden Anspruch, dadurch gekennzeichnet, dass der chemische Reinigungsschritt mit wenigstens von einem Arbeitsgang der Metallsandstrahlung begleitet ist.
3. Verfahren nach einem der vorhergehenden Ansprüche, dadurch gekennzeichnet, dass die Spülungsbäder während der chemischen Reinigungsstufe einer Ultraschall-Behandlung unterworfen sind.
4. Verfahren nch einem der vorhergehenden Ansprüche, dadurch gekennzeichnet, dass die Zeit für die thermochemische Behandlung unter 30 Minuten liegt.
5. Verfahren nach einem der vorhergehenden Ansprüche, dadurch gekennzeichnet, dass die Zeit für die thermochemische Behandlung 15 Minuten beträgt.

## Claims

1. Process of repair for articles made of heat-resistant alloys based on nickel, cobalt or iron which are fissured and damaged after exposure to gases at high temperature, particularly turbo-engine combustion gases, and bearing a surface layer contaminated with chemical compounds, characterized in that it comprises the following series of operations:

a) operations of cleaning the surfaces chemically so as to remove the said layer coating the article to be repaired, the said cleaning operations comprising the following steps:
1) removal of scale in an acidic or alkaline bath followed by a rinse;
2) conditioning of the oxides in an alkaline permanganate bath or in a molten sodium hydroxide bath followed by a rinse;
3) immersion in an acidic bath consisting of an aqueous solution of hydrochloric acid, nitric acid, acetic acid, and phosphoric acid additionally containing a ferric salt, followed by a rinse;
b) completion of the preparation by a thermochemical treatment in a semisealed enclosure comprising a case hardening composition based on ammonium fluoride and chromium, the said enclosure being placed in an oven with a controlled hydrogen atmosphere.
c) deposition onto the surface and the visible faults of an additional metal consisting of a nickel- or cobalt-based alloy and comprising an additional element which makes it more fusible than the alloy of the said article and capable of diffusing into the latter.
d) heat-brazing cycle permitting the additional metal to melt and to wet the surfaces, with a temperature rise in stages up to brazing temperature and maintaining at temperature for 15 minutes.
e) deposition onto the surface of the visible faults of a mixture consisting of at least two powders, a first powder, called a base powder, containing substantially no additional elements and of a second powder, called additional powder, containing at least nickel or cobalt and including at least one additional element which makes it more fusible than the alloy of the said article and of the said base powder.

f) second heat-brazing cycle permitting the intimate alloying of the mixture and its wetting on the surface.

g) heat-diffusion treatment under vacuum for a period of between 4 and 16 hours permitting a sufficient homogenization of the repaired region.

2. Process according to the preceding claim, characterized in that the chemical cleaning step is combined with at least one operation of metallic shot-blasting.

3. Process according to either of the preceding claims, characterized in that the rinsing baths in the chemical cleaning step are subject to ultrasonic agitation.

4. Process according to one of the preceding claims, characterized in that the duration of the thermochemical treatment is less than 30 minutes.

5. Process according to one of the preceding claims, characterized in that the duration of the thermochemical treatment is 15 minutes.